# EUROPEAN PATENT SPECIFICATION

(11) **EP 1 975 977 B1**
(45) Date of publication and mention of the grant of the patent: **04.05.2011**
(21) Application number: 08004077.7
(22) Date of filing: 05.03.2008
(51) Int. Cl.: H01L 21/00

(54) **Etching method and apparatus for a single wafer**
Ätzungsverfahren und -vorrichtung für einen Einzelwafer
Procédé et appareil de gravure d'une plaquette simple

(30) Priority: 30.03.2007 JP 2007090832
(43) Date of publication of application: 01.10.2008
(73) Proprietor: SUMCO CORPORATION, Minato-ku, Tokyo (JP)
(72) Inventor: Katoh, Takeo, Tokyo (JP); Hashii, Tomohiro, Tokyo (JP); Murayama, Katsuhiko, Tokyo (JP); Koyata, Sakae, Tokyo (JP); Takaishi, Kazushige, Tokyo (JP)
(74) Representative: Bertsch, Florian Oliver

(56) References cited:
- WO-A-02/20876
- JP-A- 2006 237 502
- US-A1- 2003 129 850

## Description

### BACKGROUND OF THE INVENTION

### 1. Field of the Invention

The present invention relates to an etching apparatus.

### 2. Description of the Related Art

In general, a semiconductor wafer manufacturing process includes steps of chamfering, mechanically polishing (lapping), etching, mirror-polishing (polishing) and cleaning a wafer obtained by cutting and slicing a single-crystal ingot, and a wafer having a highly accurate flatness degree is produced. The wafer that has been through a machining process, e.g., block cutting, external-diameter grinding, slicing, or lapping has a damaged layer, i.e., a mechanically damaged layer on an upper surface thereof. The mechanically damaged layer induces a crystal defect, e.g., a slip dislocation in a device manufacturing process, reduces mechanical strength of the wafer, and adversely affects electrical characteristics, and hence this layer must be completely removed. An etching treatment is carried out to remove this mechanically damaged layer. As the etching treatment, immersion etching or single-wafer etching is performed.

Since the single-wafer etching can control surface roughness and a texture size of a wafer having an increased diameter, it is examined as an optimum etching method. The single-wafer etching is a method for dropping an etchant onto an upper surface of a single flattened wafer and horizontally rotating (spinning) the wafer to spread the dropped etchant, thereby effecting etching. The etchant supplied to the wafer upper surface spreads on the entire wafer upper surface from a position to which the etching has been supplied by a centrifugal force caused by horizontally rotating the wafer and reaches an edge surface of the wafer, and hence the wafer upper surface and the wafer edge surface are simultaneously etched. A large proportion of the supplied etchant is blown off from the wafer edge surface by the centrifugal force and collected in, e.g., a cup provided in an etching apparatus. However, a part of the etchant flows to a wafer lower surface from the wafer edge surface. Therefore, when each single surface of the wafer is etched so that both surfaces of the wafer can be etched, there is an inconvenience that a part of the edge surface is etched twice and the edge surface cannot be uniformly etched.

To eliminate this inconvenience, there is disclosed a semiconductor substrate processing apparatus having a structure where a table portion of semiconductor substrate fixing means vacuum-sucks and holds a central portion of a discoid semiconductor substrate, rotation driving/elevating means rotates and moves up/down the semiconductor substrate together with the semiconductor substrate fixing means, and a nozzle of etchant supplying means supplies an etchant to a surface of the semiconductor substrate held by the semiconductor substrate fixing means (see, e.g., Patent Document 1). In this semiconductor substrate processing apparatus, a ring blow nozzle having a ring-like slit and a guide portion is provided to the table portion completely independently from the semiconductor substrate fixing means. The ring-like slit is provided at an outer position of the table portion and below a rear surface side of the semiconductor substrate mounted on the table portion, and configured to uniformly belch out a gas in an obliquely upper direction toward a radially outer side of a rear surface outer peripheral portion of the semiconductor substrate mounted on the table portion. Further, the guide portion is configured to lead the emitted gas to an outer end portion of the semiconductor substrate at a central position in a thickness direction along the rear surface side of the semiconductor substrate mounted on the table portion.

It has been reported that, in the thus configured semiconductor substrate processing apparatus, since the gas uniformly belched out to the rear surface outer peripheral portion of the semiconductor substrate from the ring-like slit is led to the outer end portion of the semiconductor substrate at the central position in the thickness direction, the etchant can be prevented from flowing to the lower surface side from this outer end portion, etching can be avoided at the central position of the semiconductor substrate in the thickness direction, and the edge surface can be uniformly etched when etching both surfaces of the semiconductor substrate.

### Patent Document 1

Japanese Unexamined Patent Application Publication No. 2006-237502 (claim 1, paragraph [0009])

However, in the semiconductor substrate processing apparatus disclosed in Patent Document 1 according to the conventional technology, since the guide portion leads the gas to the outer end portion of the semiconductor substrate at the central position in the thickness direction, the guide portion changes the gas belched out from the ring-like slit into an upwardly flowing gas stream from a gas stream flowing toward the radially outer side of the semiconductor substrate. Therefore, the etchant blown off by the gas belched out from the ring-like slit again adheres to the surface of the semiconductor substrate, thereby degrading a shape of the semiconductor substrate surface.

On the other hand, it was revealed from an experiment conducted by the present inventors that, when a lower surface blow mechanism that blows off the etchant flowing down on the edge surface of the wafer toward the radially outer side of the wafer by injection of the gas is adopted, adjusting, e.g., an installation position of a gas injection tip of the blow mechanism, a gas injection angle, or a gas injection amount enables suppressing the etchant from flowing toward the edge portion without using such a guide portion as explained in Patent Document 1 according to the conventional technology, thereby uniformly etching the edge portion without collapsing a chamfered shape of the edge portion.

However, when a gap between the wafer rear surface and the lower surface blow mechanism is not appropriate, the present inventors often observed a situation where the edge portion is not uniformly etched and the chamfered shape of the edge portion greatly collapses even if, e.g., a gas flow volume from the lower surface blow mechanism is adjusted so as to increase. Furthermore, it was revealed that a small irregular portion (which will be referred to as a glitter hereinafter) is produced on the edge surface of the wafer. The glitter produced on the edge surface not only results in a problem of an appearance failure of the wafer but also becomes a particle generation source when handling the wafer. When the wafer having such a glitter produced on the edge surface is subjected to epitaxial growth processing, a scale-like epitaxial film is disadvantageously formed on the edge surface.

Reference is likewise made to prior art document EP-A1-1,965,410.

### SUMMARY OF THE INVENTION

It is an object of the present invention according to claim 1 to provide a single-wafer etching method for a wafer that can uniformly etch an edge portion without collapsing a chamfered shape of the edge portion of the wafer and can prevent a glitter from being produced on an edge surface of the wafer, and an etching apparatus thereof.

As a result of keenly examining the above-explained problems, the present inventors have discovered that adjusting a gap between a lower surface blow mechanism that blows off an etchant toward a radially outer side of a wafer and a wafer rear surface to a very limited predetermined range enables uniformly etching an edge portion without collapsing a chamfered shape of the edge portion of the wafer and also enables assuredly preventing a glitter from being produced on an edge surface, thereby bringing the present invention to completion.

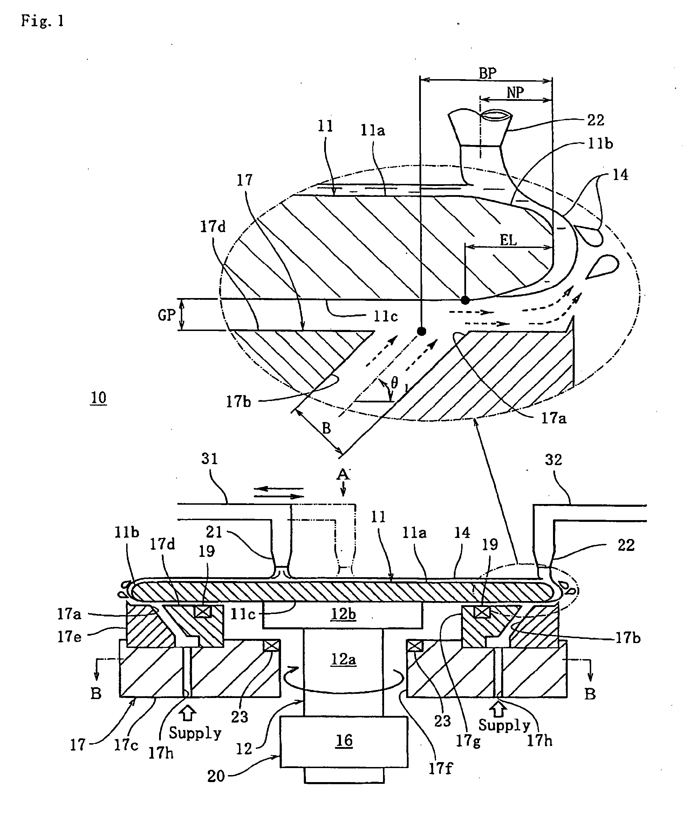

According to a first aspect not forming part of the present invention, as shown in FIG. 1, there is provided a single-wafer etching method for a wafer, which controls application of an etchant 14 to the wafer 11 in accordance with a surface shape of the wafer 11 to smooth an upper surface of the wafer 11, wherein the upper surface of the wafer 11 is smoothed in a state where a gap GP between the wafer 11 and a lower surface blow mechanism 17 which blows off the etchant 14 flowing down on an edge surface 11b of the wafer 11 toward a radially outer side of the wafer 11 by injection of a gas is adjusted to fall within the range of 0.1 to 1 mm.

In the single-wafer etching method for a wafer according to the first aspect, the wafer 11 is first rotated, and the lower surface blow mechanism 17 forms a gas flow in the gap GP between the wafer 11 and the lower surface blow mechanism 17. When the etchant 14 is supplied to an upper surface 11a of the wafer 11 in this state, the etchant 14 gradually moves toward the edge surface 11b side of the wafer 11 from a position to which the etchant 14 has been supplied while etching the upper surface 11a of the wafer 11 due to a centrifugal force produced by rotation of the wafer 11 within a horizontal plane, thereby etching the edge surface 11b of the wafer 11. Then, the etchant 14 on the wafer 11 scatters toward the outside of the wafer 11 by the centrifugal force involved by rotation of the wafer 11. On the other hand, a part of the etchant 14 that is to flow toward the lower surface 11c of the wafer 11 from the edge surface 11b of the wafer 11 is blown off toward a radially outer side of the wafer 11 by a gas stream flowing through the gap GP, and hence this etchant 4 scatters toward the outside of the wafer 11. Maintaining the gap GP in the range of 0.1 to 1 mm enables uniformly etching the edge portion without collapsing the chamfered shape of the wafer 11 and also preventing production of the glitter on the edge surface 11b of the wafer 11. Although a reason that the gap GP strongly affects production of the glitter is unknown, it can be considered that, since the wafer 11 is rotating, the gas flowing through the gap GP becomes a turbulence flow when the gap GP is wide, and the etchant 14 flows to the edge surface on the rear surface side of the wafer 11 even though it is a small amount, resulting in microscopic etching unevenness. Moreover, it can be also presumed that narrowing the gap GP straightens the gas flowing through the gap GP to prevent the etchant 14 from flowing toward the edge surface on the rear surface side of the wafer 11, thereby suppressing the etching unevenness.

Additionally, a second aspect not forming part of the present invention according to the first aspect is in that G/B is 50 to 1000 where G liters/minute is a flow volume of the gas from an injection tip 17a of the lower surface blow mechanism 17 and B mm is a width of an injection groove 17b communicating with the injection tip 17a.

As shown in FIG. 1, a first aspect of the present invention is an improvement in a single-wafer etching apparatus 10 for a wafer, which supplies an etchant 14 to an upper surface 11a of the wafer 11 while rotating the wafer 11 to etch the upper surface 11a and the edge surface 11b of the wafer 11.

Its characteristic structure comprises: wafer elevating means 16 for moving up and down the wafer 11; a lower surface blow mechanism 17 which is fixed and provided without rotating together with the wafer 11 and blows off the etchant 14 flowing down on an edge surface 11b of the wafer 11 toward a radially outer side of the wafer 11 by injection of a gas; gap detecting means 19 for detecting a gap GP between the wafer 11 and the lower surface blow mechanism 17; and gap adjusting means 20 for controlling the wafer elevating means 16 based on detection outputs detected by the gap detecting means 19 to adjust the gap GP.

In the single-wafer etching apparatus for a wafer according to the first aspect of the present invention, the wafer 11 is first rotated, and the lower surface blow mechanism 17 forms a gas flow in the gap GP between the wafer 11 and the lower surface blow mechanism 17. When the etchant 14 is supplied to an upper surface 11a of the wafer 11 in this state, the etchant 14 gradually moves toward the edge surface 11b side of the wafer 11 from a position to which the etchant 14 has been supplied while etching the upper surface 11a by a centrifugal force caused due to rotation of the wafer 11 within a horizontal plane, thereby etching the edge surface 11b of the wafer 11. Then, the etchant 14 on the wafer 11 scatters toward the outside of the wafer 11 due to the centrifugal force involved by rotation of the wafer 11. On the other hand, a part of the etchant 14 that is to flow to a lower surface 11c of the wafer from the edge surface 11b of the wafer 11 is blown off toward a radially outer side of the wafer 11 by the gas flow flowing through the gap GP, and hence this etchant 14 scatters toward the outside of the wafer 11. At this time, the wafer 11 is rotating whereas the lower surface blow mechanism 17 is fixed without being rotated, and a wafer position varies with respect to a rear surface blow position. Therefore, a centering accuracy of the wafer 11 can be excellently maintained, and the edge surface 11b can be uniformly etched over the entire circumference without collapsing a chamfered shape of the edge surface 11b of the wafer 11. In particular, since the gap GP detected by the gap detecting means 19 is fed back to the gap adjusting means 20, the gap adjusting means 20 can precisely adjust the gap GP, thereby preventing a glitter from being produced on the edge surface 11b of the wafer 11.

According to a second aspect of the present invention, there is provided a single-wafer etching apparatus for a wafer, comprising: wafer elevating means for moving up and down the wafer; a lower surface blow mechanism which is provided to relatively rotate with respect to the wafer and blows off the etchant flowing down on an edge surface of the wafer toward a radially outer side of the wafer by injection of a gas; gap detecting means for detecting a gap between the wafer and the lower surface blow mechanism; and gap adjusting means for controlling the wafer elevating means based on detection outputs detected by the gap detecting means to adjust the gap.

In the single-wafer etching apparatus for a wafer according to the second aspect, the wafer is first rotated, and the lower surface blow mechanism forms a gas flow in the gap between the wafer and the lower surface blow mechanism. When the etchant is supplied to an upper surface of the wafer in this state, the etchant gradually moves toward the edge surface side of the wafer from a position to which the etchant has been supplied while etching the wafer upper surface by a centrifugal force caused by rotation of the wafer within a horizontal plane, thereby etching the edge surface of the wafer. Then the etchant on the wafer scatters toward the outside of the wafer due to the centrifugal force involved by rotation of the wafer. On the other hand, a part of the etchant that is to flow to a lower surface of the wafer from the edge surface of the wafer is blown off toward a radially outer side of the wafer by the gas flow flowing through the gap, and hence this etchant scatters toward the outside of the wafer. At this time, the lower surface blow mechanism is relatively rotating with respect to the wafer, and a wafer position varies with respect to a rear surface blow position. Therefore, a centering accuracy of the wafer can be excellently maintained, and the edge surface on the wafer supper surface side can be uniformly etched over the entire circumference without collapsing a chamfered shape of the edge surface of the wafer. In particular, since the gap detected by the gap detecting means is fed back to the gap adjusting means, the gap adjusting means can precisely adjust the gap, thereby preventing a glitter from being produced on the edge surface of the wafer. Further, even if the gas flow flowing through the gap between the wafer and the lower surface blow mechanism has non-uniform properties, the non-uniform properties are turned to uniformity with time, thereby providing a uniform blow effect of the gas flow toward the wafer rear surface.

According to a third aspect of the present invention, there is provided the invention defined in the first or second aspect, wherein the plurality of gap detecting means 19 are arranged in a circumferential direction of the wafer 11 as shown in FIG. 1.

In the single-wafer etching apparatus for a wafer according to the third aspect, even if the gap GP between the wafer 11 and the lower surface blow mechanism 17 fluctuates depending on a measurement position, since the plurality of gap detecting means 19 accurately detect this fluctuation, the accurately detected gap GP is fed back to the gap adjusting means 20, and hence the gap GP can be accurately adjusted in an entire circumferential direction of the wafer 11. As a result, the lower surface blow mechanism 17 can form a gas flow that is straightened over the entire circumference of the wafer 11 and has a uniform flow rate in the gap between the wafer 11 and the lower surface blow mechanism 17. Consequently, since the part of the etchant 14 that is to flow to the lower surface of the wafer 11 from the edge surface 11b of the wafer 11 is uniformly blown off toward the radially outer side of the wafer 11 by the gas flow, and this etchant 14 scatters toward the outside of the wafer. Therefore, the edge surface 11b of the wafer 11 can be uniformly etched without collapsing the chamfered shape of the edge portion of the wafer 11, and a glitter can be prevented from being produced on the edge surface 11b.

According to a fourth aspect of the present invention, there is provided the invention defined in any one of the first to third aspects, wherein the gap adjusting means 20 controls lower surface blow mechanism elevating means for moving up and down the lower surface blow mechanism 17 in addition to the wafer elevating means 16 to adjust the gap GP between the wafer 11 and the lower surface blow mechanism 17.

In the single-wafer etching apparatus for a wafer according to the fourth aspect, the gap adjusting means 20 controls both the wafer elevating means 16 and the lower surface blow mechanism elevating means to adjust the gap GP between the wafer 11 and the lower surface blow mechanism 17, thereby more accurately adjusting the gap GP.

According to a fifth aspect of the present invention, as shown in FIG. 1, there is provided the invention defined in any one of the third to sixth aspects, further comprising a first nozzle 21 which supplies the etchant 14 to the upper surface 11a of the wafer 11 and a second nozzle 22 which is provided to face the edge surface 11b of the wafer 11 to supply the etchant 14 to the edge surface 11b of the wafer 11.

In the single-wafer etching apparatus according to the fifth aspect, the etchant 14 is supplied to the edge surface 11b of the wafer 11 from the second nozzle 22 provided to face the edge surface 11b of the wafer 11. As a result, adjusting an etchant supply amount from the second nozzle 22 enables intentionally changing a shape of the edge surface 11b of the wafer 11, thereby providing a target chamfered shape.

Furthermore, it is preferable that the second nozzle 22 is fixed and provided at a predetermined position that is -10 to 20 mm from an outer rim of the wafer toward a radially inner side of the wafer 11. Here, fixing the second nozzle 22 at a position that is -10 mm from an outer rim of the wafer 11 toward the radially inner side of the wafer means fixing the same at a position that is +10 mm from the outer rim of the wafer 11 toward the radially outer side of the wafer.

According to the present invention, the edge portion of the wafer can be uniformly etched without collapsing the chamfered shape of the edge portion, and a small irregular portion (glitter) can be prevented from being produced on the edge surface of the wafer.

### BRIEF DESCRIPTION OF THE DRAWINGS

FIG. 1 is a block diagram showing a vertical cross section of a primary part in a single-wafer etching apparatus for a wafer according to an embodiment of the present invention;
FIG. 2 is a view taken along an arrow A in FIG. 1 showing the etching apparatus before a wafer is mounted thereon;
FIG. 3 is a cross-sectional view taken along a line B-B in FIG. 1;
FIG. 4 is a view showing a fluctuation in a horizontal length EL of an edge surface of each wafer according to Example 1 and Comparative Example 1;
FIG. 5 is a view showing four directions along which an in-plane fluctuation in an edge surface shape of each wafer according to Example 1 and Comparative Example 1 is photographed; and
FIG. 6 is photographs showing glitter occurrence situations on the edge surface of each wafer according to Example 1 and Comparative Example 1.

### DETAILED DESCRIPTION OF THE PREFERRED EMBODIMENTS

The best mode for carrying out the present invention will now be explained with reference to the drawings.

As shown in FIG. 1, a single-wafer etching apparatus 10 includes a wafer chuck 12 that is accommodated in a chamber and horizontally holds a single thin discoid silicon wafer 11 mounted thereon, rotating means (not shown) for rotating the wafer 11 around its vertical horizontal line within a horizontal plane, a first nozzle 21 that supplies an etchant 14 to an upper surface 11a of the wafer 11 held by the chuck 12, a second nozzle 22 that supplies the etchant 14 to an edge surface 11b of the wafer 11 held by the chuck 12, wafer elevating means 16 for moving up and down the wafer 11, a lower surface blow mechanism 17 that blows off the etchant 14 flowing down on the edge surface 11b of the wafer 11 mounted on the chuck 12 toward a radially outer side of the wafer 11 by injection of a gas, lower surface blow mechanism elevating means (not shown) for moving up and down the lower surface blow mechanism 17, gap detecting means 19 for detecting a gap GP between the wafer 11 and the lower surface blow mechanism 17, and gap adjusting means 20 for adjusting the gap GP based on a detection output from this gap detecting means 19. The wafer 11 is obtained by slicing a silicon single crystal ingot, and an outer rim of this wafer 11, i.e., the edge surface 11b of the wafer 11 is chamfered into a convex shape having a predetermined curvature radius.

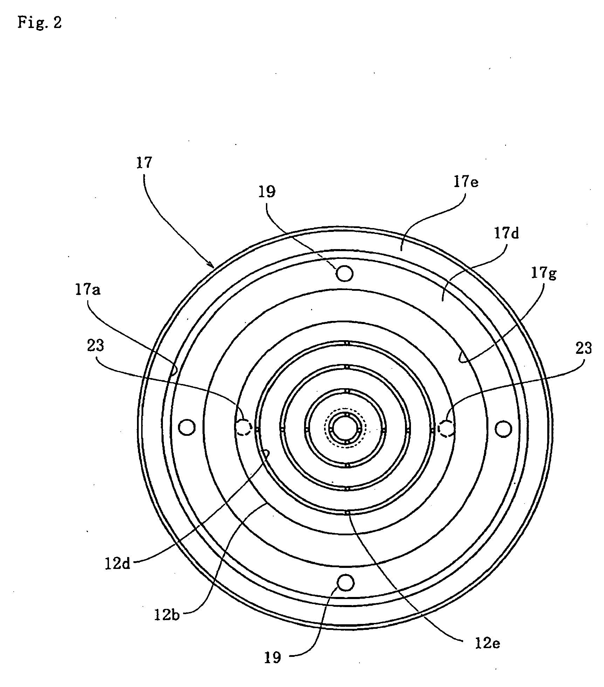

Further, the chuck 12 has a shaft portion 12a provided to extend in a vertical direction, a large-diameter wafer receiving portion 12b formed on an upper surface of the shaft portion 12a integrally with this shaft portion 12a, a through hole 12c formed at the center of the shaft portion 12a and the wafer receiving portion 12b to extend in the vertical direction from a lower surface of the shaft portion 12a to the center of the wafer receiving portion 12b, a plurality of communication holes (not shown) each of which has one end communicating and being connected with an upper end of the through hole 12c to extend to a radially outer side of the wafer receiving portion 12b in a radial pattern with the through hole 12c at the center and the other end being closed, a plurality of ring grooves 12d concentrically formed on the upper surface of the wafer receiving portion 12b, a plurality of small holes 12e that achieve communication and connection between the communication holes and the ring grooves 12d, and a vacuum pump (not shown) connected with a lower end of the through hole 12c (FIGS. 1 and 2). When the wafer 11 is mounted on the upper surface of the wafer receiving portion 12b to be concentric with the wafer receiving portion 12b and the vacuum pump is driven to form a negative pressure in each of the through hole 12c, the communication holes, the small holes 12e, and the ring groove 12d, the lower surface 11c of the wafer 11 is adsorbed by the wafer receiving portion 12b so that the wafer 11 is horizontally held. Furthermore, the rotating means has a driving motor (not shown) that rotates the shaft portion 12a. When the driving motor rotates the shaft portion 12a, the wafer 11 held by the wafer receiving portion 12b rotates together with the shaft portion 12a and the wafer receiving portion 12b.

Moreover, the first nozzle 21 is provided above the wafer 11 to face the upper surface 11a of the wafer 11, and the second nozzle 22 is provided above the edge surface 11b of the wafer 11 to face the edge surface 11b of the wafer 11. The first nozzle 21 is connected with a first supply pump (not shown) through a first supply tube 31, and the second nozzle 22 is connected with a second supply pump (not shown) through a second supply tube 32. The first nozzle 21 can be horizontally moved by first nozzle moving means (not shown) between a position where it faces the center of the upper surface 11a of the wafer 11 and a retracting position, and the second nozzle 22 can be horizontally moved by second nozzle moving means (not shown) between a position where it faces the edge surface 11b of the wafer 11 and a retracting position. When etching the wafer 11, the first nozzle 21 is moved by the first nozzle moving means between the center of the upper surface 11a of the wafer and a rim of the wafer 11, and the second nozzle 22 is fixed to the position where it faces the edge surface 11b of the wafer 11 by the second nozzle moving means. The etchant 14 is supplied through the first nozzle 21 while adjusting, e.g., a moving speed of the first nozzle or a flow volume of the etchant so as to eliminate a difference between a surface shape of the wafer before an etching treatment and a target surface shape of the wafer. For example, the etching treatment is usually performed in a state where the wafer 11 is rotating, and an etching amount at the wafer rim is larger than an etching amount near the wafer center. Therefore, moving the first nozzle 21 at the wafer outer rim while increasing its moving speed is effective. Additionally, whether the second nozzle 22 is to be adopted can be appropriately determined in accordance with a target chamfered shape of the wafer 11, and intermittently or continuously supplying the etchant from the second nozzle 22 enables more finely etching the edge portion 11b.

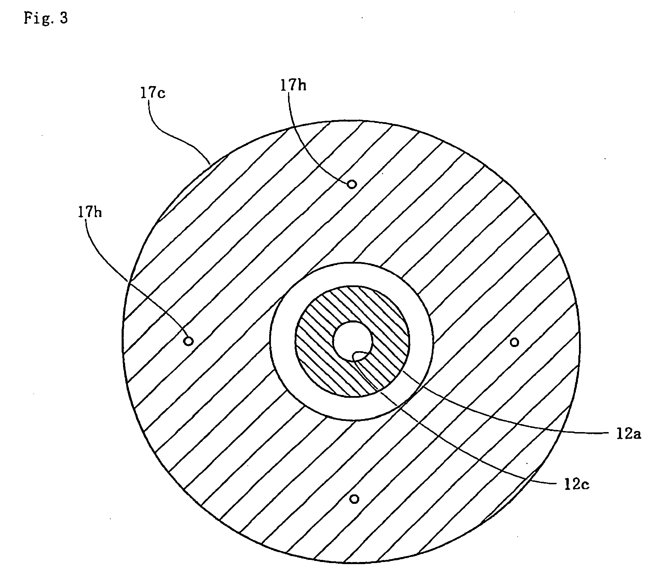

On the other hand, the lower surface blow mechanism 17 is not coupled with the wafer chuck 12 or the rotating means that rotates the wafer 11, and it is independently arranged so as not to rotate with the wafer 11. This lower surface blow mechanism 17 has a ring-like injection tip 17a facing a lower surface of the wafer 11 near the edge surface 11b, a ring-like injection groove 17b which communicates with the injection tip 17a at an upper end thereof and has a diameter gradually reduced toward the lower side, and gas supplying means (not shown) which communicates with the injection groove 17b and supplies a compressed gas to the injection tip 17a through the injection groove 17b (FIGS. 1 and 2). The injection groove 17b is formed by disposing a cone member 17d and a tapered member 17e on an upper surface of a base member 17c to be concentric with this base member 17c (FIG. 1). The base member 17c is formed to have a larger diameter than the wafer 11, and a through hole 17f is formed at the center of the base member 17c so that the shaft portion 12a is freely fitted therein. Furthermore, a large-diameter hole 17g is formed at the center of the cone member 17d, and an outer peripheral surface of the cone member 17d is formed into a conical shape in which a diameter is gradually reduced toward the lower side. An external diameter of the tapered member 17e is larger than an external diameter of the wafer 11 but smaller than an external diameter of the base member 17c, and an inner peripheral surface of the tapered member 17e is formed into a tapered shape in which a diameter is gradually reduced toward the lower side. When the tapered member 17e is mounted on the base member 17c and then the cone member 17d is mounted on the base member 17c, a ring-like gap is formed between the inner peripheral surface of the tapered member 17e and the outer peripheral surface of the cone member 17d, and this ring-like gap serves as the injection groove 17b. Moreover, the injection groove 17b communicates with one end of each of four gas supply holes 17h formed in the base member 17c (FIGS. 1 and 3), and the other end of each of these gas supply holes 17h is connected with the gas supplying means. The gas supplying means is constituted of, e.g., a compressor that compresses a gas such as a nitrogen gas or air, and the compressed gas is supplied to the injection tip 17a through the gas supply holes 17h and the injection groove 17b by this gas supplying means.

The wafer elevating means 16 is constituted of, e.g., a stepping motor or a servo motor that moves up and down the shaft portion 12a and the wafer receiving portion 12b, and the lower surface blow mechanism elevating means (not shown) is formed of, e.g., a stepping motor or a servo motor that moves up and down the lower surface blow mechanism 17. Additionally, the four gap detecting means 19 are embedded in the upper surface of the cone member 17d at predetermined intervals in a circumferential direction. These gap detecting means 19 are configured to detect the gap GP between the lower surface 11c of the wafer 11 held by the chuck 12 and the upper surface of the lower surface blow mechanism 17. As the gap detecting means 19, there is, e.g., an electrostatic capacity type or optical sensor. Further, the gap adjusting means 20 controls both the wafer elevating means 16 and the lower surface blow mechanism elevating means to adjust the gap GP between the wafer 11 and the lower surface blow mechanism 17. Furthermore, a liquid suction mechanism (not shown) is provided on the outer side that is apart from the outer peripheral surface of the wafer 11 held by the chuck 12 at a predetermined interval. Although not shown, this liquid suction mechanism has a liquid receiver that receives the etchant 14 scattering from the wafer 11 and liquid sucking means for sucking the etchant 14 received by the liquid receiver. It is to be noted that reference numeral 23 in FIGS. 1 and 2 denotes a distance sensor that measures a distance between the upper surface of the base member 17c and the lower surface of the wafer receiving portion 12b. The gap adjusting means 20 is configured to adjust the gap GP based on respective detection outputs from the gap detecting means 19 and the distance sensor 23.

It is to be noted that the gap adjusting means 20 adjusts the gap GP between the wafer 11 and the lower surface blow mechanism 17 to fall within the range of 0.1 to 1 mm or, preferably, 0.2 to 0.5 mm, and a fixed position NP of the second nozzle 22 is set to fall within the range of -10 to 20 mm or, preferably, 1 to 5 mm from the wafer outer rim toward the radially inner side of the wafer. A position BP of the injection tip 17a is set to fall within the range of 0 to 10 mm or, preferably, 1 to 5 mm from the wafer outer rim toward the radially inner side of the wafer. Further, a flow volume BF of the gas injected from the injection tip 17a is set to 50 to 1000 liters/minute or, preferably, 100 to 500 liters/minute. Assuming that a flow volume of the gas from the injection tip 17a is G liters/minute and a width of the injection groove 17b is B mm, G/B is set to 50 to 1000 or, preferably, 100 to 500. Furthermore, a rotating speed of the wafer 11 is set to fall within the range of 200 to 800 rpm or, preferably, 300 to 500 rpm, and an angle θ₁ of the injection groove 17b with respect to a horizontal plane is set to fall within the range of 5 to 60 degrees or, preferably, 10 to 45 degrees.

Here, the gap GP is restricted to the range of 0.1 to 1 mm because the wafer 11 may possibly come into contact with the cone member 17d or the tapered member 17e due to, e.g., axial wobbling at the time of rotation of the wafer 11 when the gap GP is less than 0.1 mm and the etchant flows to the edge surface on the rear side of the wafer 11 to produce a glitter on the edge surface when the gap GP exceeds 1 mm. The fixed position NP of the second nozzle 22 is restricted to the range of -1 to 20 mm from the wafer outer rim to the radially inner side of the wafer because the etchant 14 fed from the second nozzle 22 is not supplied to the edge surface on the upper surface side of the wafer 11 at all and the etchant is caused to flow to the rear surface side of the wafer 11 in case of less than -10 mm whilst the second nozzle 22 is too close to the center of the wafer 11 and a chamfered shape of the edge surface 11b of the wafer 11 cannot be formed in case of exceeding 20 mm. The position BP of the injection tip 17a is restricted to the range of 0 to 10 mm from the wafer outer rim toward the radially inner side of the wafer because the gas injected from the injection tip 17a does not reach the edge surface of the wafer 11 in case of less than 0 mm whilst the etchant flows to the rear surface of the wafer 11 in case of exceeding 10 mm. The flow volume BF of the gas injected from the injection tip 17a is restricted to the range of 50 to 1000 liters/minute because the etchant flows to the rear surface of the wafer 11 in case of less than 50 liters/minute whilst the etchant blown off by the injected gas scatters and collecting the etchant at a predetermined position becomes difficult to increase a burden on a wastewater processing facility in case of exceeding 1000 liters/minute. G/B is restricted to the range of 50 to 1000 because supply of the gas is not easy if this ratio is less than 50 whilst a gas supply flow rate cannot be sufficiently obtained when this ratio exceeds 1000. The rotating speed of the wafer 11 is restricted to the range of 200 to 800 rpm because the etchant flows to the wafer rear surface from the outer periphery of the wafer 11 and the uniform edge surface cannot be formed when the rotating speed is less than 200 rpm whilst flattening the upper surface 11a of the wafer 11 becomes difficult when the rotating speed exceeds 800 rpm. The angle θ₁ of the injection groove 17b with respect to the horizontal plane is restricted to the range of 5 to 60 degrees because the etchant flows to the rear surface of the wafer 11 when this angle is less than 5 degrees whilst the gas to be injected does not form a laminar flow and the etchant flows to the rear surface of the wafer 11 when this angle exceeds 60 degrees.

An operation of the thus configured single-wafer etching apparatus 10 for the wafer 11 will now be explained.

The gap adjusting means 20 first controls both the wafer elevating means 16 and the lower surface blow mechanism elevating means based on respective detection outputs from the plurality of gap detecting means 19 and the plurality of distance sensors 23, thereby adjusting the gap GP between the wafer 11 and the lower surface blow mechanism 17. Therefore, even if the gap GP between the wafer 11 and the lower surface blow mechanism 17 fluctuates depending on each measurement position, the plurality of gap detecting means 19 and the plurality of distance sensors 23 accurately detect this fluctuation, and hence the accurately detected gap GP is fed back to the gap adjusting means 20. Furthermore, the gap adjusting means 20 controls not only the wafer elevating means 16 but also the lower surface blow mechanism elevating means to adjust the gap GP. As a result, the gap GP is accurately adjusted to become an optimum value. Subsequently, in a state where the wafer 11 is mounted on the chuck 12, a negative pressure is formed in each of the through hole 12c, the communication holes, the small holes 12e, and the ring groove 12d by operating the vacuum pump, and the wafer 11 is horizontally held by utilizing this negative pressure. In this state, the driving motor for the rotating means is operated to rotate the wafer 11 within the horizontal plane together with the shaft portion 12a and the wafer receiving portion 12b of the chuck 12. Then, the gas supplying means of the lower surface blow mechanism 17 is operated to inject a compressed gas, e.g., a nitrogen gas or air from the injection tip 17a through the gas supply holes 17h and the injection groove 17b, thereby forming a gas flow flowing toward the radially outer side of the wafer 11 in the gap GP between the upper surface of the lower surface blow mechanism 17 and the lower surface 11c of the wafer 11, i.e., the gap GP between the upper surfaces of the cone member 17d and the tapered member 17e and the lower surface 11c of the wafer 11. Here, activating the sucking means of the liquid suction mechanism enables maintaining a negative pressure in the liquid receiver. In this state, the first nozzle moving means is operated to cause the first nozzle 21 to face the center of the wafer 11, and the second nozzle moving means is operated to cause the second nozzle 22 to face the edge surface 11b of the wafer 11. In this state, the etchant 14 is supplied from the first nozzle 21 to the upper surface 11a of the wafer 11 by activating the first supply pump, and the etchant 14 is supplied from the second nozzle 22 to the edge surface 11b of the wafer 11 by activating the second supply pump.

The etchant 14 fed to the upper surface 11a of the wafer 11 from the first nozzle 21 gradually moves from a position to which the etchant 14 has been supplied (e.g., near the center of the upper surface 11a of the wafer 11) toward the edge surface 11b of the wafer 11 while etching a mechanically damaged layer of the upper surface 11a of the wafer 11 by a centrifugal force caused by rotation of the wafer 11 within the horizontal plane. Then, when the etchant 14 reaches the edge surface 11b of the wafer 11, it etches this edge surface 11b. At this time, since an arbitrarily set amount of the etchant 14 is supplied from the second nozzle 22 to the edge surface 11b of the wafer 11, a sufficient amount of the etchant 14 required to etch the edge surface 11b of the wafer 11 is supplied. Moreover, a large part of the etchant 14 for the edge surface 11b of the wafer 11 becomes droplets to scatter toward the outside of the wafer 11 by the centrifugal force involved by rotation of the wafer 11. The scattered etchant 14 enters the liquid receiver in which a negative pressure is maintained, and it is discharged to the outside of the chamber through the suction pipe by this negative pressure. On the other hand, a part of the etchant 14 that is to flow to the lower surface 11c of the wafer 11 from the edge surface 11b of the wafer 11 is blown off toward the radially outer side of the wafer 11 by the gas flow flowing through the gap GP between the upper surface of the chuck 12 and the lower surface 11c of the wafer 11 toward the radially outer side of the wafer 11, and it scatters toward the outside of the wafer 11. The scattered etchant 14 smoothly enters the liquid receiver in which the negative pressure is maintained, and it is discharged to the outside of the chamber through the suction pipe by this negative pressure. As a result, the etched upper surface 11a of the wafer 11 can be flattened, the shape of the edge surface 11b of the wafer 11 can be arranged and stabilized, and the etchant 14 can be prevented from flowing to the lower surface 11c of the wafer 11.

It is to be noted that the lower surface blow mechanism is fixed and provided without being rotated together with the wafer in the foregoing embodiment, but the lower surface blow mechanism may be provided to relatively rotate with respect to the wafer. In this case, since the lower surface blow mechanism relatively rotates with respect to the wafer and a wafer position varies with respect to a rear surface blow position, a centering accuracy for the wafer can be excellently maintained, and wafer in-plane uniformity of the edge surface shape of the wafer can be also excellently maintained. Additionally, even if the gas flow flowing through the gap between the wafer and the lower surface blow mechanism has non-uniform properties, the non-uniform properties are turned to uniformity with time, thereby providing a uniform blow effect of the gas flow with respect to the wafer rear surface.

Further, although the gap adjusting means controls both the wafer elevating means and the lower surface blow mechanism elevating means to adjust the gap between the wafer and the lower surface blow mechanism in the foregoing embodiment, the gap adjusting means may control the wafer elevating means alone to adjust the gap between the wafer and the lower surface blow mechanism.

Furthermore, although the injection tip is formed into the ring-like shape in the foregoing embodiment, the injection tip may be formed into a shape having a plurality of pores.

Moreover, although the gap adjusting means adjusts the gap between the wafer and the lower surface blow mechanism based on respective detection outputs from the plurality of gap detecting means and the plurality of distance sensors in the foregoing embodiment, the gap adjusting means may adjust the gap between the wafer and the lower surface blow mechanism based on detection outputs from the plurality of gap detecting means alone.

Additionally, the four gap detecting means are embedded in the upper surface of the cone member in the circumferential direction at predetermined intervals in the foregoing embodiment, the number of the gap detecting means may be two, three, five, or more.

### EXAMPLES

Next, an example according to the present invention is explained together with a comparative example.

### Example 1

As shown in FIG. 1, the single-wafer etching apparatus 10 was used to etch the silicon wafer 11 having a diameter of 300 mm and a thickness of 0.8 mm. Here, the gap adjusting means 20 adjusted the gap GP between the upper surface of the lower surface blow mechanism 17 and the lower surface 11c of the wafer 11 to 0.4 mm, and the position BP of the injection tip 17a was set to a position that is 3 mm from the wafer outer rim toward the radially inner side of the wafer. Furthermore, the flow volume BF of the gas injected from the injection tip 17a was set to 500 liters/minute, and G/B was set to 500 where G liters/minute is a flow volume of the gas from the injection tip 17a and B mm is a width of the injection groove 17b. Moreover, the rotating speed of the wafer 11 was set to 400 rpm, the angle θ₁ of the injection groove 17b with respect to the horizontal plane was set to 30 degrees, the flow volume of the etchant 14 emitted from the first nozzle 21 was set to 3 liters/minute, the first nozzle 21 was moved from the center of the wafer 11 toward the rim portion of the wafer 11 while increasing the speed, thereby supplying the etchant 14. The wafer 11 etched by this apparatus 10 was determined as Example 1. It is to be noted that the second nozzle 22 was not used in this example.

### Comparative Example 2

A wafer was etched like Example 1 except that the gap adjusting means adjusted the gap GP between the wafer and the lower surface blow mechanism to 1.5 mm. This wafer was determined as Comparative Example 1.

### Comparative Test 1 and Evaluation

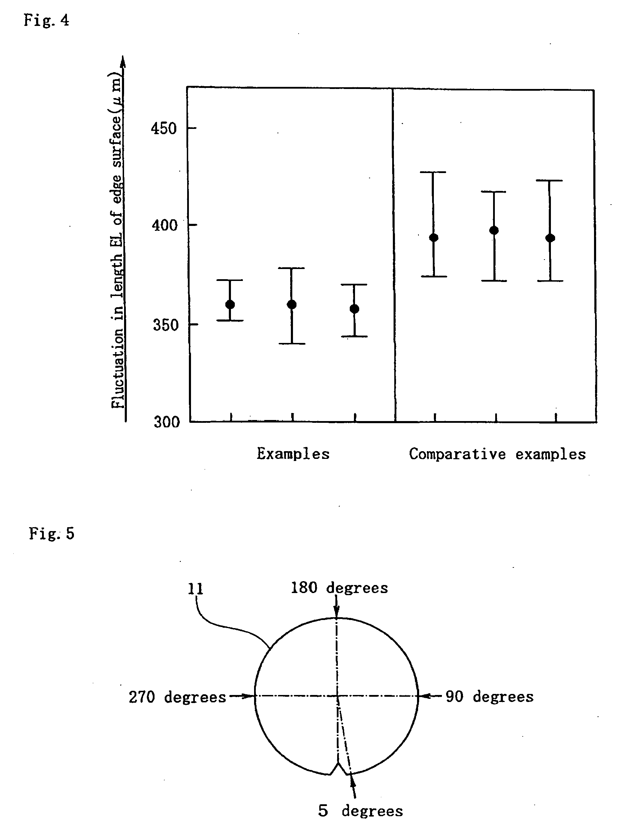

A length EL (FIG. 1) of an edge surface in the horizontal direction was measured in each of the three wafers according to Example 1 and the three wafers according to Comparative Example 1, and a fluctuation in the length EL was obtained in accordance with each wafer. FIG. 4 shows its result.

As apparent from FIG. 4, it was revealed that the length EL of the edge surface in the horizontal direction is as long as approximately 400 µm in each wafer according to Comparative Example 1 whereas the length EL of the edge surface in the horizontal direction is as short as approximately 370 µm in each wafer according to Example 1. Additionally, it was understood that the fluctuation in the length EL of the edge surface in the horizontal direction is as large as 46 to 52 µm in each wafer according to Comparative Example 1 whereas the fluctuation in the length EL of the edge surface in the horizontal direction is as small as 20 to 37 µm in each wafer according to Example 1.

### Comparative Test 2 and Evaluation

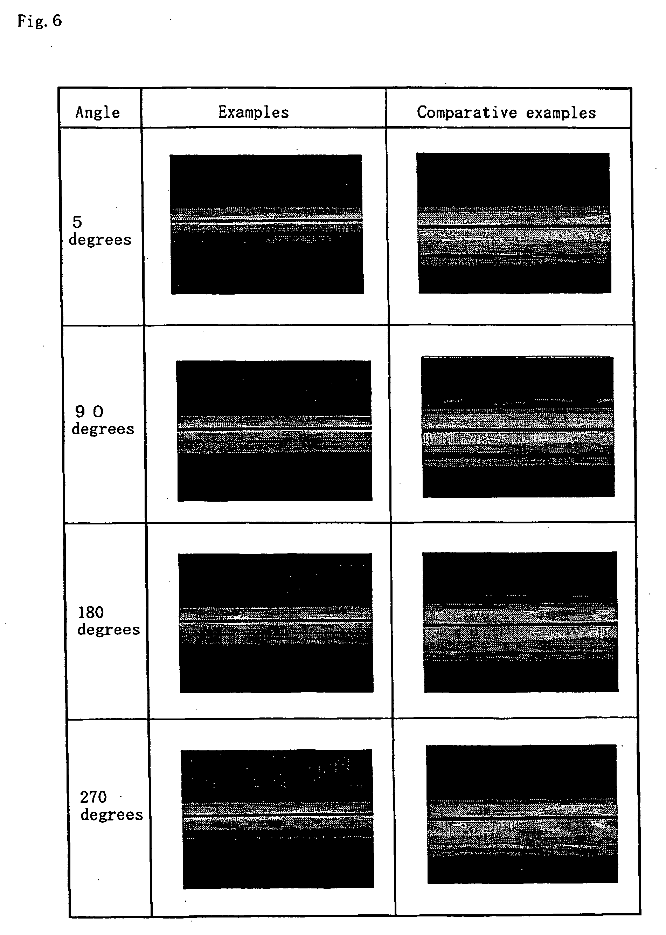

An outer peripheral surface of each wafer obtained according to Example 1 and Comparative Example 1 was photographed from four directions (a direction having an angle of five degrees, a direction having an angle of 90 degrees, a direction having an angle of 180 degrees, and a direction having an angle of 270 degrees in FIG. 5), and a glitter production situation on the edge surface of each wafer was observed. FIG. 6 shows its result.

As apparent from FIG. 6, a glitter was produced on the edge surface of each wafer according to Comparative Example 1 whereas production of the glitter was not observed on the edge surface of each wafer according to Example 1. It is to be noted that production of the glitter on the edge surface of the wafer was not observed even though the gap GP was changed to 1 mm under the conditions of Example 1.

## Claims

1. A single-wafer etching apparatus for a wafer (11), which supplies an etchant (14) to an upper surface (11a) of the wafer while rotating the wafer to etch the upper surface of the wafer, the apparatus comprising:
wafer elevating means (16) for moving up and down the wafer;
a lower surface blow mechanism (17) which is provided to relatively rotate with respect to the wafer and blows off the etchant (14) flowing down on an edge surface of the wafer toward a radially outer side of the wafer by injection of a gas;
**characterized by** further comprising
gap detecting means (19) for detecting a gap (GP) between the wafer (11) and the lower surface blow mechanism (17); and
gap adjusting means (20) for controlling the wafer elevating means based on detection outputs detected by the gap detecting means (19) to adjust the gap (GP).

2. The single-wafer etching apparatus for a wafer (11) according to claim 1, wherein the lower surface blow mechanism (17) is fixed and provided without rotating together with the wafer (11).

3. The single-wafer etching apparatus for a wafer according to claim 1 or 2, wherein the plurality of gap detecting means are arranged in a circumferential direction of the wafer.

4. The single-wafer etching apparatus for a wafer according to any one of claims 1 to 3, wherein the gap adjusting means (20) controls lower surface blow mechanism elevating means for moving up and down the lower surface blow mechanism (17) in addition to the wafer elevating means (16) to adjust the gap (GP) between the wafer (11) and the lower surface blow mechanism (17).

5. The single-wafer etching apparatus for a wafer according to any one of claims 1 to 4, further comprising a first nozzle (21) which supplies the etchant (14) to the upper surface of the wafer and a second nozzle (22) which is provided to face the edge surface of the wafer (11) to supply the etchant (14) to the edge surface of the wafer.

6. The single-wafer etching apparatus for a wafer according to claim 5, wherein the second nozzle (22) is fixed and provided at a predetermined position that is -10 to 20 mm from an outer rim of the wafer (11) toward a radially inner side of the wafer.

## Patentansprüche

1. Einzelwaferätzvorrichtung für einen Wafer (11), welche ein Ätzmittel (14) zu einer oberen Fläche (11a) des Wafers zuführt, während sich der Wafer dreht, um die obere Fläche des Wafers zu ätzen, wobei die Vorrichtung umfasst:
Waferhebemittel (16) zum Herauf- und Herunterbewegen des Wafers;
einen Blasmechanismus (17) für eine untere Fläche, welcher vorgesehen ist, sich relativ bezogen auf den Wafer zu drehen und das Ätzmittel (14), welches an einer Randfläche des Wafers nach unten fließt, in Richtung einer radialen Außenseite des Wafers durch Einblasen eines Gases wegzublasen;
**dadurch gekennzeichnet, dass** sie ferner umfasst
Abstandserfassungsmittel (19) zum Erfassen eines Abstands (GP) zwischen dem Wafer (11) und dem Blasmechanismus (17) für die untere Fläche; und
Abstandseinstellmittel (20) zum Steuern des Waferhebemittels basierend auf Erfassungsausgaben, welche von dem Abstandserfassungsmittel (19) erfasst wurden, um den Abstand (GP) einzustellen.

2. Einzelwaferätzvorrichtung für einen Wafer (11) nach Anspruch 1, wobei der Blasmechanismus (17) für die untere Fläche ortsfest und ohne sich zusammen mit dem Wafer (11) zu drehen vorgesehen ist.

3. Einzelwaferätzvorrichtung für einen Wafer nach Anspruch 1 oder 2, wobei die mehreren Abstandserfassungsmittel in einer Umfangsrichtung des Wafers angeordnet sind.

4. Einzelwaferätzvorrichtung für einen Wafer nach einem der Ansprüche 1 bis 3, wobei das Abstandseinstellmittel (20) Blasmechanismushebelmittel für eine untere Fläche zum Herauf- und Herunterbewegen des Blasmechanismus (17) für die untere Fläche zusätzlich zu dem Waferhebemittel (16) steuert, um den Abstand (GP) zwischen dem Wafer (11) und dem Blasmechanismus (17) für die untere Fläche einzustellen.

5. Einzelwaferätzvorrichtung für einen Wafer nach einem der Ansprüche 1 bis 4, ferner umfassend eine erste Düse (21), welche das Ätzmittel (14) zu der oberen Fläche des Wafers zuführt, und eine zweite Düse (22), welche vorgesehen ist, um der Randfläche des Wafers (11) gegenüber zu liegen, um das Ätzmittel (14) zu der Randfläche des Wafers zuzuführen.

6. Einzelwaferätzvorrichtung für einen Wafer nach Anspruch 5, wobei die zweite Düse (22) ortsfest und an einer vorbestimmten Position vorgesehen ist, welche -10 bis 20mm von einem Außenrand des Wafers (11) in Richtung einer radialen Innenseite des Wafers ist.

## Revendications

1. Appareil de gravure de plaquette unique pour une plaquette (11), qui alimente un agent de gravure (14) à une surface supérieure (11a) de la plaquette tout en faisant tourner la plaquette pour graver la surface supérieure de la plaquette, l'appareil comprenant :
des moyens d'élévation de plaquette (16) pour faire monter et descendre la plaquette ;
un mécanisme de soufflage de surface inférieure (17) qui est prévu pour tourner relativement par rapport à la plaquette et souffler l'agent de gravure (14) qui s' écoule sur une surface de bord de la plaquette vers le côté radialement externe de la plaquette par injection d'un gaz ;
**caractérisé en ce qu'**il comprend en outre :
des moyens de détection d'espace (19) pour détecter un espace (GP) entre la plaquette (11) et le mécanisme de soufflage de surface inférieure (17) ; et
des moyens d'ajustement d'espace (20) pour contrôler les moyens d'élévation de plaquette en fonction des sorties de détection détectées par les moyens de détection d'espace (19) afin d'ajuster l'espace (GP) .

2. Appareil de gravure de plaquette unique pour une plaquette (11) selon la revendication 1, dans lequel le mécanisme de soufflage de surface inférieure (17) est fixe et prévu sans tourner conjointement avec la plaquette (11).

3. Appareil de gravure de plaquette unique pour une plaquette selon la revendication 1 ou 2, dans lequel la pluralité de moyens de détection d'espace sont agencés dans une direction circonférentielle de la plaquette.

4. Appareil de gravure de plaquette unique pour une plaquette selon l'une quelconque des revendications 1 à 3, dans lequel les moyens d'ajustement d'espace (20) commandent les moyens d'élévation de mécanisme de soufflage de surface inférieure pour faire monter et descendre le mécanisme de soufflage de surface inférieure (17) en plus des moyens d'élévation de plaquette (16) afin d'ajuster l'espace (GP) entre la plaquette (11) et le mécanisme de soufflage de surface inférieure (17).

5. Appareil de gravure de plaquette unique pour une plaquette selon l'une quelconque des revendications 1 à 4, comprenant en outre une première buse (21) qui alimente l'agent de gravure (14) à la surface supérieure de la plaquette et une deuxième buse (22) qui est prévue pour faire face à la surface de bord de la plaquette (11) afin d'alimenter l'agent de gravure (14) à la surface de bord de la plaquette.

6. Appareil de gravure de plaquette unique pour une plaquette selon la revendication 5, dans lequel la deuxième buse (22) est fixe et prévue dans une position prédéterminée qui est de -10 à 20 mm à partir d'un bord externe de la plaquette (11) vers un côté radialement interne de la plaquette.
